Europäisches Patentamt

European Patent Office

Office européen des brevets

(19)

(11) Veröffentlichungsnummer: **0 065 062**
B1

# (12) EUROPÄISCHE PATENTSCHRIFT

(45) Veröffentlichungstag der Patentschrift:
14.08.85

(51) Int. Cl.⁴: **H 03 K 3/78**

(21) Anmeldenummer: **82100055.1**

(22) Anmeldetag: **07.01.82**

(54) **Verfahren zur Erzeugung von digitalen periodischen Zeitfunktionssignalen.**

(30) Priorität: **07.05.81 CH 2960/81**

(43) Veröffentlichungstag der Anmeldung:
**24.11.82 Patentblatt 82/47**

(45) Bekanntmachung des Hinweises auf die Patenterteilung:
**14.08.85 Patentblatt 85/33**

(84) Benannte Vertragsstaaten:
**AT BE DE FR NL SE**

(56) Entgegenhaltungen:
**US - A - 3 937 899**
**US - A - 4 254 327**

**ELECTRONIC DESIGN, Band 27, Nr. 12, 7 Juni 1979 P.R.**
**HARDAKER "EPROMs are the building blocks for**
**expandable universal timing generator" Seite 120**

(73) Patentinhaber: **LGZ LANDIS & GYR ZUG AG,**
**CH-6301 Zug (CH)**

(72) Erfinder: **Neyer, Norbert, Forchstrasse 141,**
**CH-8032 Zürich (CH)**

(74) Vertreter: **Müller, Hans-Jürgen, Dipl.-Ing. et al, Müller,**
**Schupfner & Gauger**
**Lucile-Grahn-Strasse 38 Postfach 80 13 69,**
**D-8000 München 80 (DE)**

## Beschreibung

### Anwendungsgebiet und Zweck

Die Erfindung bezieht sich auf ein Verfahren zur Erzeugung von binären periodischen Zeitfunktionssignalen gemäss dem Oberbegriff des Anspruchs 1.

Zeitfunktionssignale dieser Art werden z.B. als Referenzsignale in Kohärenz-Empfängern für den Empfang von z.B. «Chirp»-Signalen benötigt. In solchen Kohärenz-Empfängern wird ein Empfangssignal, welches möglicherweise gestört ist, zwecks Detektion des Nutzsignals und Eliminierung des Störanteils einerseits mit dem Referenzsignal selber und andererseits mit dem um 90° phasenverschobenen Referenzsignal multipliziert.

### Stand der Technik

Aus der US-PS 4 254 327 ist ein Verfahren und eine Einrichtung bekannt zur Erzeugung binärer Zeitfunktionssignale, wobei zur Erzeugung der Impulslücken in einem Festwertspeicher Zeitinformationen gespeichert sind, die angeben, wann eine Impulslücke beendet ist, d.h. wann ein neuer Impuls zu beginnen hat, dessen Dauer zwar programmierbar, jedoch während des Betriebes konstant ist und vom Festwertspeicherinhalt unabhängig erzeugt wird. Die durch die in der Fig. 4 der US-PS 4 254 327 dargestellte Schaltung erzeugte Impulslücke ist gleich der Zählablaufzeit des 16 Bit-Adressezählers 204 und damit maximal gleich $2^{16}$ Taktimpulszeiten.

Ein Kohärenz-Empfänger ist in der US-PS Nr. 3 937 899, Spalte 2, Zeile 49 bis Spalte 3, Zeile 43 beschrieben, allerdings für den relativ einfachen Fall, dass das Referenzsignal eine reine Sinus- oder Kosinusfunktion ist und amplitudenmässig in einem Speicher abgespeichert ist.

### Aufgabe und Lösung

Der Erfindung liegt die Aufgabe zugrunde, binäre periodische Zeitfunktionssignale beliebiger binärer Form aufwandsökonomisch so zu erzeugen, dass die zeitliche Länge sowohl der Impulslücken als auch der Impulsdauer grösser sein kann als die maximale Zählablaufzeit des zum Festwertspeicher zugehörigen Adressezählers und dass unter Beibehaltung einer hohen Auflösungsgenauigkeit der benötigte Speicherbedarf des Festwertspeichers relativ gering ist. Die Frequenzgenauigkeit bei z.B. 40 kHz sollte z.B. annähernd 100 Hz betragen.

Die genannte Aufgabe wird erfindungsgemäss durch die im Kennzeichen des Patentanspruchs 1 angegebenen Merkmale gelöst.

Ein weiterer Vorteil der Erfindung ist, dass die relativ langen Einschwingzeiten der Festwertspeicherdaten keinen störenden Einfluss auf die Erzeugung der Zeitfunktionssignale bewirken.

### Beschreibung

Ein Ausführungsbeispiel der Erfindung ist in der Zeichnung dargestellt und wird im folgenden näher beschrieben. Es zeigen:

Fig. 1 ein Blockschaltbild eines Funktionsgenerators,

Fig. 2 eine schematische Darstellung der zu speichernden Datenwerte und

Fig. 3 ein Schaltbild einer Logikschaltung.

Gleiche Bezugszahlen bezeichnen in allen Figuren der Zeichnung gleiche Teile. In der Zeichnung sind die Rückstelleingänge der einzelnen Zähler und Flip Flop mit C (C = «Clear»), die Setzeingänge mit P (P = «Preset») und die Takteingänge mit einem weissen Dreieck, wenn sie positiv gehende Flanken auswerten bzw. mit einem schwarzen Dreieck gekennzeichnet, wenn sie negativ gehende Flanken auswerten. Alle verwendeten Flip Flop sind D-Flip Flop.

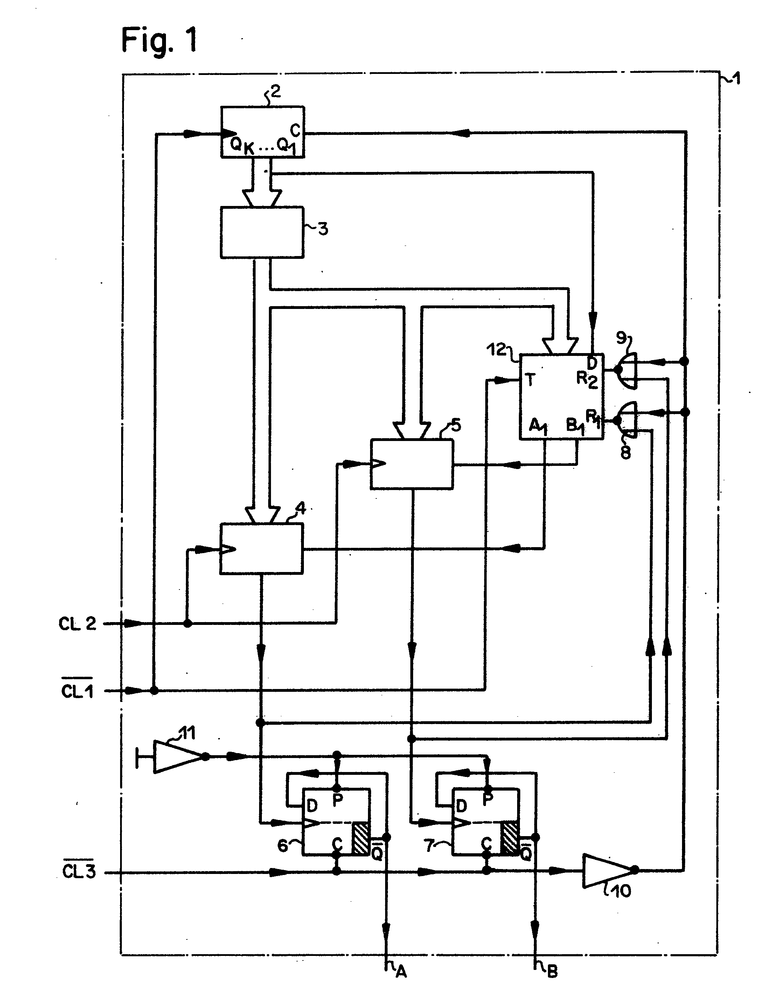

### Beschreibung der Fig. 1

Ein in der Fig. 1 dargestellter Funktionsgenerator 1 zur Erzeugung zweier binärer und periodischer Zeitfunktionssignale enthält einen Adressezähler 2, einen Festwertspeicher 3, einen ersten Periodenzähler 4, einen zweiten Periodenzähler 5, einen ersten Signal-Flip Flop 6, einen zweiten Signal-Flip Flop 7, ein erstes «Nor»-Gatter 8, ein zweites «Nor»-Gatter 9, einen ersten Inverter 10, einen zweiten Inverter 11 und eine Logikschaltung 12.

Der Funktionsgenerator 1 besitzt einen ersten, einen zweiten und einen dritten Takteingang, die in der angegebenen Reihenfolge von einem invertierten ersten Taktsignal CL1, von einem zweiten Taktsignal CL2 und von einem invertierten dritten Taktsignal CL3 gespeist werden. Er hat ausserdem einen ersten Signalausgang A für das erste erzeugte Zeitfunktionssignal, z.B. ein «1-Chirp»-Signal, und einen zweiten Signalausgang B für das zweite Zeitfunktionssignal, z.B. ein «0-Chirp»-Signal.

Einpolig miteinander verbunden sind:
— der erste Takteingang des Funktionsgenerators 1 mit dem jeweiligen Takteingang des Adressezählers 2 und der Logikschaltung 12;
— der zweite Takteingang des Funktionsgenerators 1 mit dem jeweiligen Takteingang des ersten und des zweiten Periodenzählers 4 und 5;
— der dritte Takteingang des Funktionsgenerators 1 mit dem jeweiligen Rückstelleingang C des ersten und des zweiten Signal-Flip Flop 6 und 7 sowie über den Inverter 10 mit dem jeweiligen ersten Eingang des ersten und des zweiten «Nor»-Gatters 8 und 9 und dem Rückstelleingang C des Adressezählers 2;
— der niederwertigste Bit-Ausgang $Q_1$ des Adressezählers 2 mit einem einpoligen Dateneingang D der Logikschaltung 12;
— ein erster Ausgang $A_1$ der Logikschaltung 12 mit einem Freigabeeingang des ersten Periodenzählers 4 und ein zweiter Ausgang $B_1$ der Logikschaltung 12 mit einem Freigabeeingang des zweiten Periodenzählers 5;
— der Ausgang des ersten Periodenzählers 4 mit dem Takteingang des ersten Signal-Flip Flop 6 und einem zweiten Eingang des ersten «Nor»-Gatters 8;
— der Ausgang des zweiten Periodenzählers 5 mit dem Takteingang des zweiten Signal-Flip Flop 7 und einem zweiten Eingang des zweiten «Nor»-Gatters 9;
— der Ausgang des ersten «Nor»-Gatters 8 mit einem ersten Rückstelleingang $R_1$ und der Ausgang des zweiten «Nor»-Gatters 9 mit einem zweiten Rückstelleingang $R_2$ der Logikschaltung 12;

— der D-Eingang des ersten Signal Flip Flop 6 mit dessen $\overline{Q}$-Ausgang und dem ersten Signalausgang A des Funktionsgenerators 1;

— der D-Eingang des zweiten Signal-Flip Flop 7 mit dessen $\overline{Q}$-Ausgang und dem zweiten Signalausgang B des Funktionsgenerators 1.

Der Masseanschluss des Funktionsgenerators 1 liegt über den Inverter 11 an den jeweiligen Setzeingängen P der beiden Signal-Flip Flop 6 und 7.

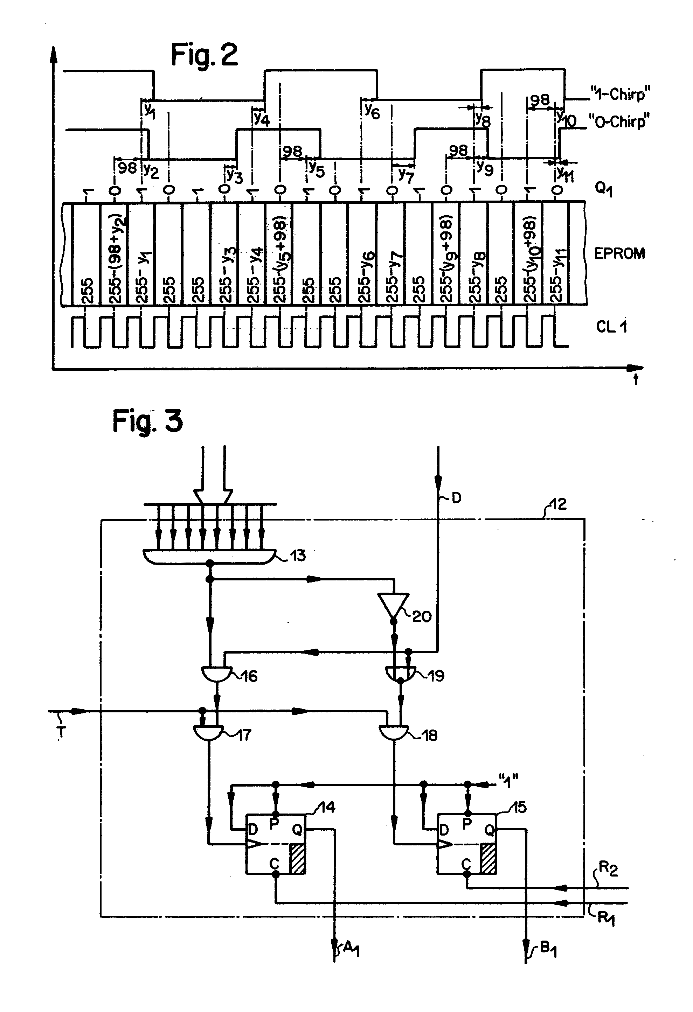

Alle Zähler sind Binärzähler. Der Adressezähler 2 ist ein K-Bit Zähler, dessen K Ausgänge $Q_1$, $Q_2$,..., $Q_K$ über einen K-Bit Datenbus auf den K-Bit Adresseingang des Festwertspeichers 3 geführt ist. Im folgenden wird angenommen, dass K = 11 ist. Dann kann als Adressezähler 2 z.B. ein 12-Bit CMOS-Zähler vom Typ MC 14 040 der Firma Motorola, Phoenix, Arizona, USA, verwendet werden unter Vernachlässigung des obersten, zwölften Bit, und als Festwertspeicher 3 kann ein 2K-EPROM, z.B. vom Typ 2716 der Firma Intel, Santa Clara, Californien, USA, eingesetzt werden, da $2^{11} = 2048$ ist. Alle restlichen Bauelemente sowohl der Fig. 1 als auch der Fig. 3 können Bauelemente der «Low Power Schottky»-Reihe 74LS... der Firma Texas Instr., Dallas, Texas, USA, sein.

Die im Festwertspeicher 3 gespeicherten digitalen Datenwerte besitzen N-Bit, mit z.B. N = 8. Die N-Bit Datenausgänge $Q_1^*$, $Q_2^*$,..., $Q_N^*$ des Festwertspeichers 3 sind mit Hilfe von N-Bit Datenbusverbindungen mit dem jeweiligen N-Bit Paralleleingang der beiden Periodenzähler 4 und 5 sowie mit dem N-Bit Eingang der Logikschaltung 12 verbunden. Als 8 Bit-Periodenzähler 4 und 5 können z.B. je zwei 4 Bit-Binärzähler, z.B. vom Typ 74LS163 in Kaskadenschaltung verwendet werden, wobei ihre beiden «Carry»-Ausgänge auf die beiden Eingänge je eines zusätzlichen, nicht gezeichneten «And»-Gatters zu führen sind, dessen Ausgang den Ausgang des betreffenden Periodenzählers bildet. Die Freigabeeingänge solcher 8 Bit-Periodenzähler 4 bzw. 5 sind dann die parallelgeschalteten beiden «Load»-Eingänge der beiden 4 Bit-Binärzähler und der mit diesen verbundene T-Eingang des ersten dieser beiden 4 Bit-Binärzähler. Alle verwendeten D-Flip Flop, auch diejenigen der Fig. 3, sind z.B. vom Typ 74LS74. Desgleichen können als Inverter in beiden Figuren 74LS04 eingesetzt werden.

*Funktionsbeschreibung der Schaltung nach Fig. 1*

Die beiden im Funktionsgenerator 1 erzeugten Zeitfunktionssignale sind z.B. «Chirp»-Signale, und zwar erscheint z.B. am ersten Ausgang A des Funktionsgenerators 1 ein «1-Chirp»-Signal, in einem Nachrichtensystem z.B. den Wert «logisch 1» darstellend, und am zweiten Ausgang B ein «0-Chirp»-Signal, in dem Nachrichtensystem z.B. den Wert «logisch 0» repräsentierend. Während einer Periode T der Zeitfunktionssignale ändert sich die Frequenz der rechteckförmigen «Chirp»-Signale nach einer beliebigen mathematischen Funktion von der Anfangsfrequenz $f_{B,i}$ bis zur Endfrequenz $f_{E,i}$, wobei sich der Index i = 0 auf das «0-Chirp»-Signal und der Index i = 1 auf das «1-Chirp»-Signal bezieht.

Es gilt z.B.:

$$f_{E,1} - f_{B,1} = f_{E,0} - f_{B,0} = 2 \text{ kHz und}$$

$$f_{B,0} - f_{B,1} = 400 \text{ Hz.}$$

Werden diese «Chirp»-Signale als Referenzsignale in einem Kohärenz-Empfänger verwendet und empfängt dieser Nachrichtensignale, welche über die Leitungen eines Energieversorgungsnetzes übertragen werden, so beträgt die höchste Endfrequenz $f_{E,i}$ des Referenzsignals annähernd 40 kHz und die tiefste Anfangsfrequenz $f_{B,i}$ wird z.B. gleich 10 kHz gewählt:

Die Periode $T_3$ des dritten Taktsignals CL3 ist gleich der Periode T der Zeitfunktionssignale und die Dauer ihrer Impulse z.B. annähernd 1 $\mu$s oder mindestens kleiner als eine viertel Periode $T_1$ des ersten Taktsignals CL1. Aus Netzsynchronisierungsgründen ist die Periode $T_3$ vorteilhafterweise gleich einer halben Periode der Netzfrequenz zu wählen, in Europa also gleich 10 ms, was einer Frequenz $f_3 = 100$ Hz entspricht. In diesem Fall wird das dritte Taktsignal CL3 z.B. mit Hilfe von Komparatoren, z.B. vom Typ LM311 der Firma National Semiconductor, Santa Clara, Californien, USA, und einem monostabilen Multivibrator, z.B. vom Typ 74LS221, auf bekannte und daher nicht dargestellte Art und Weise netzsynchron erstellt. Zu Beginn einer jeden Periode T der Zeitfunktionssignale bringt die positiv gehende Flanke des dritten Taktsignals CL3 den Funktionsgenerator 1 in die Ausgangslage zurück, indem alle Signal-Flip Flop 6 und 7 direkt, der Adressezähler 2 über den Inverter 10 und alle Freigabe-Flip Flop der Logikschaltung 12 zusätzlich noch über die beiden «Nor»-Gatter 8 und 9 auf Null zurückgestellt werden. Von diesem Augenblick an beginnt der Adressezähler 2 von Null an die negativ gehenden Flanken des invertierten ersten Taktsignals CL1 binär zu zählen. Diese negativ gehenden Flanken des invertierten ersten Taktsignals CL1 entsprechen zeitlich den positiv gehenden Flanken des nicht invertierten ersten Taktsignals CL1. Der K-Bit Zählwert des Adressezählers 2 erhöht sich fortlaufend, und damit auch der K-Bit Wert der Adressen des Festwertspeichers 3. Die Adressen rufen nacheinander und fortlaufend die N-Bit Datenwerte $x_j$ aller Speicherzellen des Festwertspeichers 3 ab. Jedem der beiden Funktionssignale sind bestimmte Speicherzellen des Festwertspeichers 3 zugeordnet. Da der Ladeeingang «Load» der beiden Periodenzähler 4 und 5 an logisch «0» liegt, wie später noch anhand der Fig. 3 erläutert wird, werden diese N-Bit Datenwerte $x_j$ direkt nach ihrem Erscheinen an den N-Bit Paralleleingängen der beiden Periodenzähler 4 und 5 mit der nächsten positiv gehenden Flanke des zweiten Taktsignals CL2, dessen Frequenz $f_2$ ein Vielfaches der Frequenz $f_1$ des ersten Taktsignals CL1 ist, in die Periodenzähler 4 und 5 geladen.

Wegen den relativ langen Einschwingzeiten der Festwertspeicherdaten erfolgt die Auswertung der Daten durch die beiden Periodenzähler 4 bzw. 5, falls sie freigegeben ist, zeitverzögert zu deren Ladevorgang. Vorteilhafterweise wird als Zeitverzögerung eine halbe Periode $T_1/2$ des ersten Taktsignals CL1 gewählt. Diese Zeitverzögerung wird bei der Erstellung der Daten für den Festwertspeicher 3 bereits im voraus berücksichtigt.

Die Adressen des Festwertspeichers 3 können auf die beiden folgenden Arten den beiden Zeitfunktionssignalen zugeordnet sein:

— Entweder haben die Datenwerte $x_j$ beider Zeitfunktionssignale gleiche Adressen, dann erfolgt die Freigabe der Auswertung der beiden Periodenzähler 4 und 5 gleichzeitig, mit dem Nachteil, dass der Bedarf an Speicherzellen sehr gross ist. Es bedarf in diesem Fall zweier Speicherzellen pro Adresse, also zweier getrennter Festwertspeicher 3, die parallel betrieben werden.

— Oder den Datenwerten $x_j$ beider Zeitfunktionssignale sind verschachtelte, abwechselnde Adressen zugeordnet, z.B. dem «1-Chirp»-Signal ungeradzahlige Adressen, deren niederwertigstes Bit $Q_1 = 1$, und dem «0-Chirp»-Signal geradzahlige Adressen, deren niederwertigstes Bit $Q_1 = 0$. In diesem Fall erfolgt die Auswertefreigabe der beiden Periodenzähler 4 und 5 nicht gleichzeitig, sondern abwechselnd zeitlich nacheinander. Im folgenden wird immer dieser Fall angenommen, da er der wirtschaftlich interessantere ist. Es kann dabei die Hälfte der Speicherzellen eingespart werden.

Die Logikschaltung 12 gibt in diesem Fall in der Mitte der Periode $T_1$ des ersten Taktsignals CL1, d.h. zur Zeit der negativ gehenden Flanke, falls eine bestimmte Bedingung nicht erfüllt ist, z.B. dass der abgerufene Datenwert des Festwertspeichers 3 gleich 255 ist,

— mit einem Ausgangssignal am ersten Ausgang $A_1$ die Auswertung des Periodenzählers 4, wenn z.B. $Q_1 = 1$, und

— mit einem Ausgangssignal am zweiten Ausgang $B_1$ die Auswertung des zweiten Periodenzählers 5 frei, wenn z.B. $Q_1 = 0$.

Nach Beendigung der Auswertung erscheint am Ausgang des betreffenden Periodenzählers 4 bzw. 5 eine logische «1», die einerseits über eines der beiden «Nor»-Gatter 8 bzw. 9 die Logikschaltung 12 und damit die Auswertung des Periodenzählers 4 bzw. 5 erneut sperrt und die andererseits mit ihrer positiv gehenden Flanke den zum betreffenden Periodenzähler 4 bzw. 5 gehörenden, von $\overline{Q}$ nach D rückgekoppelten Signal-Flip Flop 6 bzw. 7 umschaltet. Dadurch wird die Wertigkeit von dessen $\overline{Q}$-Ausgangssignal im richtigen Augenblick geändert. Dieses $\overline{Q}$-Ausgangssignal ist gleichzeitig das zugehörige, am betreffenden Signalausgang A bzw. B des Funktionsgenerators 1 erscheinende Zeitfunktionssignal, das zu erzeugen war.

Das erste Taktsignal CL1 wird auf bekannte und daher nicht dargestellte Art und Weise durch binäre Teilung von der Frequenz $f_2$ des zweiten Taktsignals CL2 synchron abgeleitet, z.B. mit Hilfe zweier 4 Bit-Binärzähler vom Typ 74LS163 in Kaskadenschaltung mit nachgeschaltetem zusätzlichem D-Flip Flop vom Typ 74LS74. Das zweite Taktsignal CL2 wird z.B. mit Hilfe eines Quarz-Oszillators vom Typ 74LS321 erzeugt und speist parallel die Takteingänge der beiden 4 Bit-Binärzähler, deren Kaskadenschaltung als 8 Bit-Binärzähler funktioniert.

Zahlenbeispiel:

Die Frequenz $f_2$ des zweiten Taktsignals CL2 sei 20 MHz. Die dazugehörige Periode $T_2$ ist dann 0,05 $\mu s$. In dem 8 Bit-Binärzähler wird z.B. der binäre Gegenwert der Zahl 207 geladen, so dass dieser Binärzähler die Impulse des zweiten Taktsignals CL2 zählt von 207 bis $2^8 = 256$, d.h. 49 Werte, um anschliessend mit Hilfe seines «Carry»-Ausgangssignals und eines zusätzlichen Inverters z.B. vom Typ 74LS04 über die «Load»-Eingänge wieder ein Laden der Binärzahl 207 zu veranlassen. Die Frequenz $f_2 = 20$ MHz des zweiten Taktsignals CL2 wird somit durch 49 geteilt. Die erhaltene Frequenz wird im nachgeschalteten D-Flip Flop noch einmal, diesmal durch 2, geteilt, so dass der Gesamtteiler gleich $2 \cdot 49 = 98$ ist. Die so erzeugte Frequenz $f_1$ des ersten Taktsignals CL1 hat demnach den Wert $f_2/98 = 20$ MHz/$98 = 204,081$ kHz, was einer Periode $T_1 = 4,9$ $\mu s$ entspricht. Da der Adressezähler 2 die Impulse des ersten Taktsignals CL1 zählt, kann er während einer Periode von z.B. $T = T_3 = 10$ ms der zu erzeugenden Zeitfunktionssignale 10 ms/4,9 $\mu s$ = 2040 Adressen abrufen, so dass das vorgeschaltete 2k-EPROM vom Typ 2716 mit seinen $2^{11} = 2048$ Speicherzellen vollauf genügt.

Jedoch ist bei der Dimensionierung der Frequenz $f_1$ des ersten Taktsignals CL1 zu beachten, dass bei einem gegebenen Wert der Frequenz $f_1$ der zeitliche Abstand zwischen zwei aufeinanderfolgenden Änderungen der binären Werte der zu erzeugenden Zeitfunktionssignale einen bestimmten Wert nicht unterschreiten darf, da ansonsten die zwei auf die beiden aufeinanderfolgenden Änderungen bezogenen Datenwerte $x_j$ unter der gleichen Adresse abgespeichert werden müssten, was unmöglich ist.

Die N-Bit Datenwerte $x_j$ des Festwertspeichers 3 liegen während einer Periode $T_1 = 4,9$ $\mu s$ des ersten Taktsignals CL1, d.h. während 98 Perioden $T_2 = 0,05$ $\mu s$ des zweiten Taktsignals CL2, an den N-Bit Paralleleingängen der beiden Periodenzähler 4 und 5. Sie werden zu Beginn der Periode $T_1$ in diese geladen und bleiben in diesen so lange gespeichert bis entweder die Auswertung freigegeben wird oder, falls dies nicht erfolgt, bis zu Beginn der nächsten Periode $T_1$, wenn der nächste N-Bit Datenwert $x_j$ geladen wird.

Die im Festwertspeicher 3 abgespeicherten Datenwerte $x_j$ stellen die zu erzeugenden Zeitfunktionssignale nicht amplituden- sondern zeitmässig dar, und zwar ausgedrückt in Anzahl Perioden $T_2$ des zweiten Taktsignals CL2. Jeder Änderung des binären Wertes des zu erzeugenden Zeitfunktionssignals entspricht ein Datenwert $x_j$. Im folgenden wird angenommen, dass dieser Datenwert $x_j$ unter der letzten, vor Erscheinen der Änderung des binären Wertes abgerufenen, dem betreffenden Zeitfunktionssignal zugehörigen Adresse abgespeichert ist. Bei der Zuordnung der Adressen ist dabei zu beachten, dass der für jede Änderung des binären Wertes geltende Zeitbereich gegenüber dem Adresse-Abrufbereich zeitverschoben ist, wobei im vorliegenden Beispiel angenommen wurde, dass diese Zeitverschiebung eine halbe Periode $T_1$, d.h. $98/2 = 49$ Perioden $T_2$, beträgt.

Besitzen alle Zeitfunktionssignale gleiche Adressen, so werden mindestens 98 Datenwerte $x_j$ pro Periode $T_1$ benötigt. Sind dagegen die Adressen von h Zeitfunktionssignalen verschachtelt, so bedarf es mindestens 98·h Datenwerte $x_j$. Da in diesem Beispiel der letztere Fall angenommen wurde, sind für die Erzeugung von h = 2 Zeitfunktionssignalen mindestens 98·2 = 196 Datenwerte $x_j$ erforderlich.

In diesem Fall kann N = 8 gewählt werden, da die Anzahl Datenwerte $x_j$ dann $2^8$ = 256 beträgt. Diese besitzen somit Werte von 0 bis 255, welche für jedes zu erzeugende Zeitfunktionssignal z.B. mit Hilfe eines Computerprogramms berechnet werden können.

Da 196 sinnvolle Datenwerte benötigt werden bei der Erzeugung von 2 Zeitfunktionssignalen mit verschachtelten Adressen, besitzen die Werte 1 bis 196 eine sinnvolle konkrete Bedeutung, d.h. sie bezeichnen, gerechnet von der negativ gehenden Flanke des ersten Taktsignals CL1 an, die Anzahl der zu zählenden Perioden $T_2$ des zweiten Taktsignals CL2 bis zur Erzeugung der nächsten Wertigkeitsänderung des zugehörigen Zeitfunktionssignals.

Die Werte 1 bis 98 werden benötigt, wenn die Änderung der binären Werte eines Zeitfunktionssignals in den für dieses Zeitfunktionssignal geltenden, um eine halbe Periode $T_1$ zeitverschobenen Auswertebereich fällt. Die um den Wert 98 höheren Werte 99 bis 196 dagegen, wenn seine Änderung in dem für das andere Zeitfunktionssignal geltenden, ebenfalls zeitverschobenen Auswertebereich liegt. Werden die Datenwerte 1 bis 98 mit $y_j$ bezeichnet, so können die Datenwerte 99 bis 196 mit ($y_j$ + 98) bezeichnet werden.

Die restlichen Datenwerte von $x_j$, die ausserhalb des Zahlenbereichs 1 bis 196 liegen, sind an sich bedeutungslos, jedoch wird einem bestimmten dieser Datenwerte, z.B. dem Datenwert 255, die Bedeutung «Keine Änderung des binären Wertes» zugeordnet. In der Praxis wird dieser Datenwert 255 in der Regel in den meisten Speicherzellen abgespeichert sein. Diese Tatsache ist der tiefere Grund dafür, dass eine verschachtelte Adressierung und damit eine Einsparung von Speicherzellen möglich ist.

Sind die beiden Periodenzähler 4 und 5 Rückwärtszähler, so beginnt ein Periodenzähler 4 bzw. 5 vom geladenen Datenwert $x_j$ an rückwärts bis Null zu zählen, sobald er in der Mitte einer Periode $T_1$ des ersten Taktsignals CL1 freigegeben wird. Wenn nach Ablauf des Zählvorganges der Nullwert erreicht wird, ist der richtige Augenblick für eine Änderung des binären Wertes des zugehörigen Zeitfunktionssignals gekommen, da der Periodenzähler 4 bzw. 5 inzwischen $x_j$ Perioden $T_2$ des zweiten Taktsignals CL2 gezählt hat. Eine logische «1» erscheint am Ausgang des Periodenzählers 4 bzw. 5, deren positiv gehende Flanke den nachgeschalteten Signal-Flip Flop 6 bzw. 7 somit im richtigen Augenblick zum Kippen bringt und damit im richtigen Moment eine Änderung des zugehörigen Zeitfunktionssignals realisiert.

Wird dagegen für den Periodenzähler 4 bzw. 5 kein Rückwärts- sondern ein Vorwärtszähler, wie z.B. der angegebene Typ 74LS163, benutzt, so sind in den Speicherzellen des Festwertspeichers 3 nicht die Datenwerte $x_j$, sondern die Werte (255 - $x_j$) zu speichern, die dann die Werte 255 - 196 = 59 bis 255 - 1 = 254 annehmen können. Verwendet man, wie in der Fig. 2, die Bezeichnung $y_j$, so sind in diesen Speicherzellen die Datenwerte (255 - $y_j$) bzw. [255 - ($y_j$

+ 98)] zu speichern. Dabei ist die allgemeine Bezeichnung für 255 gleich ($N^2$ - 1).

Gemäss der Fig. 4 des Standes der Technik US-PS 4 254 327 ist unter Vernachlässigung des kleinen Teilerverhältnisses des 4 Bit-Zählers 208 die Taktfrequenz des Periodenzählers 204 gleich der Taktfrequenz des Adressezählers 320. Unter der Annahme, dass die letzere Frequenz — wie im schon oben erwähnten Beispiel — gleich $f_1$ = 204,081 kHz gewählt wird, werden für den ungünstigsten Fall der Erzeugung eines Zeitfunktionssignals der Frequenz 40 kHz maximal 204,081 kHz/40 kHz = 5 Abtastwerte pro Periode des Zeitfunktionssignals erzeugt, was einer Genauigkeit der Änderung der binären Werte von ± 40 kHz/5 = ± 8 kHz entspricht. Durch die vorstehend beschriebene neue Methode werden dagegen im gleichen Fall ($f_2$ = 20 MHz) 20 MHz/40 kHz = 500 Abtastwerte pro Periode des Zeitfunktionssignals maximal erzeugt, was einer Genauigkeit von ± 40 kHz/500 = ± 80 Hz entspricht. Das heisst der Fehler ist 100mal kleiner.

*Beschreibung der Fig. 2*

Im Diagramm nach der Fig. 2 wird als Abszisse die Zeit t verwendet. In der ersten Zeile der Fig. 2 ist das zu erzeugende «1-Chirp»-, in der zweiten Zeile das «0-Chirp»-Signal als Impulsdiagramm dargestellt. In der dritten Zeile sind die abwechselnden 0/1-Werte des niederwertigsten Bit $Q_1$ der Festwertspeicher-Adressen und in der fünften Zeile die Impulse des ersten Taktsignals CL1 wiedergegeben. Zeile 4 ist eine schematische Darstellung der im Festwertspeicher 3 gespeicherten, im Augenblick der positiv gehenden Flanke des ersten Taktsignals CL1 abzurufenden Datenwerte (255 - $y_j$) bzw. [255 - ($y_j$ + 98)].

Dem Diagramm ist eine verschachtelte Adressierung der beiden «Chirp»-Signale zugrundegelegt. Alle Adressenfelder der Zeile 4, die sich unter einem 0-Wert von $Q_1$ befinden, gehören somit zum «0-Chirp»-Signal, und die restlichen, sich unter einem 1-Wert von $Q_1$ befindenden Adressenfelder, zum «1-Chirp»-Signal. Es ist zu beachten, dass $y_j$ immer die Anzahl Perioden $T_2$ bis zur Mitte eines Adressenfeldes darstellt.

Die Fig. 2 lässt die verschiedenen möglichen relativen Lagen der Änderung der binären Werte der beiden «Chirp»-Signale in Relation mit den zugehörigen Adressenfeldern und den zu speichernden Datenwerten (255 - $y_j$) bzw. [255 - ($y_j$ + 98)] erkennen.

*Beispiel*

Die letzte negativ gehende Flanke des «0-Chirp»-Signals erfolgt in einem Augenblick, wo gerade der Datenwert (255 - $y_8$) des «1-Chirp»-Signals ausgewertet wird (gerechnet von Feldmitte bis Feldmitte) oder allgemeiner formuliert, wo gerade ein Datenwert des «1-Chirp»-Signals hätte ausgewertet werden können, da dort ja auch ein nichtausgewerteter Datenwert 255 des «1-Chirp»-Signals hätte gespeichert sein können. Der zur Flanke des «0-Chirp»-Signals gehörende Datenwert $y_9$ muss daher ein Adressenfeld früher abgespeichert werden, und zwar nicht als Wert (255 - $y_9$), sondern als Wert [255 - ($y_9$ + 98)].

*Beschreibung der Fig. 3*

Die in der Fig. 3 näher dargestellte Logikschaltung 12 besteht aus einem «Nand»-Gatter 13 mit N = 8 Eingängen, welche den N-Bit Eingang der Logikschaltung 12 bilden, einem ersten Freigabe-Flip Flop 14, einem zweiten Freigabe-Flip Flop 15, einem ersten «And»-Gatter 16, einen zweiten «And»-Gatter 17, einem dritten «And»-Gatter 18, einem dritten «Nor»-Gatter 19 und einem dritten Inverter 20.

Der Ausgang des «Nand»-Gatters 13 speist einen ersten Eingang des ersten «And»-Gatters 16 und über den dritten Inverter 20 einen ersten Eingang des dritten «Nor»-Gatters 19. Der jeweils zweite Eingang des ersten «And»-Gatters 16 und des dritten «Nor»-Gatters 19 sind miteinander und mit einem einpoligen Dateneingang D der Logikschaltung 12 verbunden. Der Ausgang des ersten «And»-Gatters 16 liegt an einem ersten Eingang des zweiten «And»-Gatters 17 und der Ausgang des dritten «Nor»-Gatters 19 an einem ersten Eingang des dritten «And»-Gatters 18. Die jeweils zweiten Eingänge des zweiten und des dritten «And»-Gatters 17 und 18 sind miteinander und mit einem Takteingang T der Logikschaltung 12 verbunden. Der Ausgang des zweiten «And»-Gatters 17 steuert den Takteingang des ersten Freigabe-Flip Flop 14 und derjenige des dritten «And»-Gatters 18 denjenigen des zweiten Freigabe-Flip Flop 15. Die D- und die Setzeingänge P beider Freigabe-Flip Flop 14 und 15 liegen alle an logisch «1». Der Q-Ausgang des ersten Freigabe-Flip Flop 14 ist auf den ersten Ausgang $A_1$ und derjenige des zweiten Freigabe-Flip Flop 15 auf den zweiten Ausgang $B_1$ der Logikschaltung 12 geschaltet. Der erste Rückstelleingang $R_1$ der Logikschaltung 12 liegt am Rückstelleingang C des ersten Freigabe-Flip Flop 14 und sein zweiter Rückstelleingang $R_2$ am Rückstelleingang C des zweiten Freigabe-Flip Flop 15.

*Funktionsbeschreibung der Schaltung nach der Fig. 3*

Am N-Bit Eingang der Logikschaltung liegen z.B. die N-Bit Datenwerte $x_j$ und an seinem Dateneingang D das niederwertigste Bit $Q_1$ der zu den Datenwerten gehörenden Adresse des Festwertspeichers 3.

Ist der Datenwert $x_j$ verschieden von 255 ≙ 11111111 und ist die zugehörige Adresse geradzahlig, d.h. ist $Q_1 = 0$, so erscheint am Ausgang des dritten «Nor»-Gatters 19 eine logische «1», welche mit Hilfe des dritten «And»-Gatters 18 das invertierte erste Taktsignal CL1 vom Takteingang T der Logikschaltung 12 auf den Takteingang des zweiten Freigabe-Flip Flop 15 durchschaltet, so dass dieses zur Zeit der positiv gehenden Flanke des invertierten ersten Taktsignals CL1 umschaltet und die Auswertung des zugehörigen zweiten Periodenzählers 5 in der Fig. 1 freigibt.

Ist der Datenwert $x_j$ verschieden von 255 ≙ 11111111 und ist die zugehörige Adresse diesmal ungeradzahlig, d.h. ist $Q_1 = 1$, so erscheint diesmal am Ausgang des ersten «And»-Gatters 16 eine logische «1», welche diesmal mit Hilfe des zweiten «And»-Gatters 17 das invertierte erste Taktsignal CL1 auf den Takteingang diesmal des ersten Freigabe-Flip Flop 14 durchschaltet, so dass dieses im richtigen Augenblick die Auswertung diesmal des ersten Periodenzählers 4 in der Fig. 1 freigibt.

Die Rückstellung des jeweiligen Freigabe-Flip Flop 14 bzw. 15 erfolgt jeweils am Ende der Auswertung, wenn am Ausgang des zugehörigen Periodenzählers 4 bzw. 5 eine logische «1» erscheint, über das erste «Nor»-Gatter 8 der Fig. 1 und den ersten Rückstelleingang $R_1$ bzw. über das zweite «Nor»-Gatter 9 der Fig. 1 und den zweiten Rückstelleingang $R_2$. Ist die Auswertung des betreffenden Periodenzählers 4 bzw. 5 nicht freigegeben, so steht an seinem Freigabeeingang eine logische «0» an, welche das Laden des Periodenzählers freigibt.

**Patentansprüche**

1. Verfahren zur gleichzeitigen Erzeugung von mehreren binären periodischen Zeitfunktionssignalen beliebiger binärer Form, denen je eine bestimmte Anzahl Speicherzellen eines Festwertspeichers zugeordnet sind, die mit Hilfe von Flanken eines ersten Taktsignals (CL1), dessen Frequenz ($f_1$) den zu erzeugenden Zeitfunktionssignalen angepasst ist, zeitseriell nacheinander abgerufen werden, und die je einen Datenwert ($x_j$) enthalten, der angibt, nach wieviel Perioden eines zweiten Taktsignals (CL2), dessen Frequenz ($f_2$) ein Vielfaches der Frequenz ($f_1$) des ersten Taktsignals (CL1) ist — jeweils gerechnet von einer gegenüber einem Abrufaugenblick der betreffenden Speicherzelle zeitverzögerten Auswertefreigabe dieser Speicherzelle an — das zugehörige binäre periodische Zeitfunktionssignal das nächste Mal seinen binären Wert zu ändern hat, wobei die Datenwerte ($x_j$) eines jeden Zeitfunktionssignals in je einem Periodenzähler (4 bzw. 5) pro Zeitfunktionssignal geladen werden, deren Zählvorgang jeweils durch die Auswertefreigabe begonnen wird und die nach Ablauf des Zählvorgangs einen nachgeschalteten Signal-Flip Flop (6 bzw. 7) zum Umschalten bringen, dadurch gekennzeichnet, dass ein bestimmter, nicht als Perioden-Zählwert verwendeter Datenwert angibt, dass bis zum Beginn der Auswertung der nächsten Speicherzellen-Adresse des betreffenden Zeitfunktionssignals keine Änderung des binären Wertes stattfindet, und dass die von der Anzahl ($x_j$) der Perioden ($T_2$) des zweiten Taktsignals (CL2) beanspruchte Zeit kleiner oder gleich der Periode ($T_1$) des ersten Taktsignals (CL1) gewählt wird, wenn alle Zeitfunktionssignale gleiche Speicherzellen-Adressen besitzen, oder kleiner oder gleich h mal der Periode ($T_1$) des ersten Taktsignals (CL1) gewählt wird, wenn h die Anzahl der zu erzeugenden Zeitfunktionssignale darstellt und aufeinanderfolgende Speicherzellen-Adressen den verschiedenen Zeitfunktionssignalen abwechselnd verschachtelt zugeordnet werden.

2. Verfahren nach Anspruch 1, dadurch gekennzeichnet, dass binäre «Chirp»-Signale als Zeitfunktionssignale gewählt werden.

3. Verfahren nach Anspruch 1 oder 2, dadurch gekennzeichnet, dass zwei Zeitfunktionssignale erzeugt werden, wobei einem ersten der Wert «logisch 1» und dem zweiten der Wert «logisch 0» zugeordnet wird.

4. Verfahren nach Anspruch 3, dadurch gekennzeichnet, dass dem ersten Zeitfunktionssignal die ungeradzahligen Speicherzellen-Adressen und dem zweiten Zeitfunktionssignal die geradzahligen Speicherzellen-Adressen zugeordnet sind oder umgekehrt.

5. Verfahren nach einem der Ansprüche 1 bis 4, dadurch gekennzeichnet, dass die Periodenzähler (4 bzw. 5) Rückwärtszähler sind.

6. Verfahren nach einem der Ansprüche 1 bis 4, dadurch gekennzeichnet, dass die Periodenzähler (4 bzw. 5) Vorwärtszähler sind und die Werte $(2^N 1 - x_j)$ in den Speicherzellen gespeichert sind, wenn die Periodenzähler (4 bzw. 5) N-Bit Zähler sind.

7. Verfahren nach einem der Ansprüche 1 bis 6, dadurch gekennzeichnet, dass die Zeitverzögerung zwischen Abrufaugenblick und Auswertebeginn der gleichen Speicherzelle gleich der halben Periode $(T_1/2)$ des ersten Taktsignals (CL1) ist.

8. Verfahren nach einem der Ansprüche 1 bis 7, dadurch gekennzeichnet, dass die Periode T der Zeitfunktionssignale gleich der halben Periode der Netzfrequenz eines Energieversorgungsnetzes ist.

9. Verfahren nach einem der Ansprüche 1 bis 8, dadurch gekennzeichnet, dass zu Beginn der Periode T der Zeitfunktionssignale eine netzsynchrone allgemeine Rückstellung erfolgt.

10. Verfahren nach einem der Ansprüche 1 bis 9, dadurch gekennzeichnet, dass die Zeitfunktionssignale Referenzsignale eines Kohärenz-Empfängers sind.

11. Verfahren nach Anspruch 10, dadurch gekennzeichnet, dass der Kohärenz-Empfänger an den Leitungen eines Energieversorgungsnetzes angeschlossen ist, zwecks Empfang von Nachrichtensignalen, die über diesen übertragen werden.

## Claims

1. A process for simultaneously producing a plurality of binary periodic time function signals of any binary form, with which are respectively associated a given number of memory cells of a read only memory which are successively recalled in a time-serial mode by means of edges of a first clock signal (CL1) whose frequency $(f_1)$ is matched to the time funktion signals to be produced, and which respectively contain a data value $(x_j)$ which specifies after how many periods of a second clock signal (CL2) whose frequency $(f_2)$ is a multiple of the frequency $(f_1)$ of the first clock signal (CL1) — reckoned in each case from an evaluation release of the respective memory cell which is time-delayed in comparison with a recall time of that memory cell — the associated binary periodic time function signal next has to alter its binary value, wherein the data values $(x_j)$ of each time function signal are loaded in a respective period counter (4 or 5 respectively) per time function signal, whose counting operation is respectively begun by the evaluation release and which, after conclusion of the counting operation, cause a downstream-connected signal flip-flop (6 or 7 respectively) to switch over, characterised in that a given data value which is not used as a period counting value specifies that no change in the binary value occurs until the beginning of evaluation of the next memory cell address of the respective time function signal, and that the time required by the number $(x_j)$ of the periods $(T_2)$ of the second clock signal (CL2) is selected to be less than or equal to the period $(T_1)$ of the first clock signal (CL1) when all time function signals have the same memory cell addresses or is selected to be smaller than or equal to h times the period $(T_1)$ of the first clock signal (CL1) when h represents the number of time function signals to be produced and successive memory cell addresses are associated alternately in nested mode with the various time function signals.

2. A process according to claim 1, characterised in that binary chirp signals are used as the time function signals.

3. A process according to claim 1 or claim 2, characterised in that two time function signals are produced, wherein the value «logic 1» is associated with a first signal and the value «logic 0» is associated with the second signal.

4. A process according to claim 3, characterised in that the odd-numbered memory cell addresses are associated with the first time function signal and the even-numbered memory cell addresses are associated with the second time function signal or vice-versa.

5. A process according to one of claims 1 to 4, characterised in that the period counters (4 or 5 respectively) are down counters.

6. A process according to one of claims 1 to 4, characterised in that the period counters (4 or 5 respectively) are up counters and the values $(2^N 1 - x_j)$ are stored in the memory cells when the period counters (4 or 5 respectively) are N-bit counters.

7. A process according to one of claims 1 to 6, characterised in that the time delay between the recall time and the commencement of evaluation of the same memory cell is equal to half the period $(T_1/2)$ of the first clock signal (CL1).

8. A process according to one of claims 1 to 7, characterised in that period T of the time function signals is equal to half the period of the mains frequency of a power supply mains system.

9. A process according to one of claims 1 to 8, characterised in that mains-synchronous general resetting is effected at the beginning of the period T of the time function signals.

10. A process according to one of claims 1 to 9, characterised in that the time function signals are reference signals of a coherence receiver.

11. A process according to claim 10, characterised in that the coherence receiver is connected to the lines of a power supply mains system, for the purpose of receiving communication signals which are transmitted by way thereof.

## Revendications

1. Procédé pour la génaration simultanée de plusieurs signaux périodiques fonction du temps de forme binaire quelconque, auxquels sont attribués à chacun une quantité déterminée de cases de mémoire d'une mémoire fixe qui, à l'aide de flancs d'un premier signal d'horloge (CL1) dont la fréquence ($f_1$) est adaptée aux signaux à créer fonction du temps, sont appelées en série dans le temps l'une après l'autre, et qui contiennent chacune une valeur de données ($x_j$) qui précise, après combien de périodes d'un second signal d'horloge (CL2) dont la fréquence ($f_2$) est un multiple de la fréquence ($f_1$) du premier signal d'horloge (CL1) — chaque fois calculé à partir d'un déblocage retardé de dépouillement d'une case de mémoire vis-à-vis d'un instant d'interrogation de cette case en question — le signal binaire périodique fonction du temps ressortissant qui doit modifier sa valeur binaire la fois suivante, les valeurs de données ($x_j$) de chacun des signaux de fonction de temps approvisionnant chacun un compteur de périodes (4 ou 5) par signal fonction du temps, dont le processus de comptage a commencé chaque fois par la libération du dépouillement et qui, après déroulement du comptage, met en sens inverse une bascule bistable de signal (6 ou 7) placée en aval, caractérisé en ce qu'une valeur de données déterminée, non utilisée comme valeur de comptage de périodes, précise que, jusqu'au début du dépoulliment de l'adresse suivante de case de mémoire du signal de fonction de temps en question, aucune modification de la valeur binaire n'a lieu, et en ce que le temps exigé de la quantité ($x_j$) des périodes ($T_2$) du second signal d'horloge (CI2) est choisi inférieur ou égal à période ($T_1$) du premier signal d'horloge (CL1) quand tous les signaux de fonction de temps possèdent les mêmes adresses de cases de mémoire, ou est choisi inférieur ou égal à h fois de la période ($T_1$) du premier signal d'horloge (CL1), quand h représente la quantité des signaux fonctions du temps à produire, et des adresses de cases de mémoire consécutives sont attibuées alternativement imbriquées aux divers signaux de fonction de temps.

2. Procédé selon la revendication 1, caractérisé en ce que des signaux «Chirp» binaires sont choisis comme signaux fonctions du temps.

3. Procédé selon la revendication 1 ou 2, caractérisé en ce que deux signaux fonctions du temps sont créés, la valeur «1» logique étant attribuée à l'un, et au second, la valeur «0» logique.

4. Procédé selon la revendication 3, caractérisé en ce qu'au premier signal fonction du temps sont attribuées les adresses de cases de mémoire impaires, et au deuxième signal de fonction de temps, les adresses paires, ou inversement.

5. Procédé selon l'une des revendications 1 à 4, caractérisé en ce que les compteurs de périodes (4 ou 5) sont des compteurs à rebours.

6. Procédé selon l'une des revendications 1 à 4, caractérisé en ce que les compteurs de périodes (4 ou 5) sont des compteurs positifs et les valeurs ($2^N - x_j$) sont stockées dans les cases de mémoire, quand les compteurs de périodes (4 ou 5) sont des compteurs à N bits.

7. Procédé selon l'une des revendications 1 à 6, caractérisé en ce que le retard entre l'instant d'appel et le début du dépouillement de la même case de mémoire est égal a la demi-période $T_1/2$ du premier signal d'horloge (CL1).

8. Procédé selon l'une des revendications 1 à 7, caractérisé en ce que la période T des signaux de fonction de temps est égale à la demi-période de la fréquence du secteur d'un réseau d'alimentation d'énergie.

9. Procédé selon l'une des revendications 1 à 8, caractérisé en ce que, au commencement de la période T des signaux fonctions du temps, se produit un rappel général à zéro en synchronisme avec le secteur.

10. Procédé selon l'une des revendications 1 à 9, caractérisé en ce que les signaux fonctions du temps sont des signaux de référence d'un récepteur à cohérence.

11. Procédé selon la revendication 10, caractérisé en ce que le récepteur à cohérence est raccordé aux lignes d'un réseau d'alimentation d'énergie, en vue de la réception de signaux de télécommunications, qui sont transmis par ce réseau.

Fig. 1

0 065 062

9

# Fig. 2

# Fig. 3